**Europäisches Patentamt**

**European Patent Office**

**Office européen des brevets**

(11) Veröffentlichungsnummer: **0 385 258**
**A2**

## EUROPÄISCHE PATENTANMELDUNG

(21) Anmeldenummer: **90103367.0**

(22) Anmeldetag: **22.02.90**

(51) Int. Cl.⁵: **H04B 15/00, H04R 3/00**

(30) Priorität: **28.02.89 DE 3906157**

(43) Veröffentlichungstag der Anmeldung:
**05.09.90 Patentblatt 90/36**

(84) Benannte Vertragsstaaten:
**AT BE CH DE DK ES FR GB GR IT LI LU NL SE**

(71) Anmelder: **Havenith, Hans**
**Schulze-Delitzsch-Strasse 35**
**D-5000 Köln 51(DE)**

(72) Erfinder: **Havenith, Hans**
**Schulze-Delitzsch-Strasse 35**
**D-5000 Köln 51(DE)**

(74) Vertreter: **Berkenfeld, Helmut, Dipl.-Ing.**
**An der Schanz 2**
**D-5000 Köln 60(DE)**

(54) **Schaltungsanordnung zur Ausschaltung von Potentialdifferenzen und zur Signallinearisierung.**

(57) Die Schaltungsanordnung wird in hochwertigen Tonaufnahme- und -wiedergabeanlagen verwandt. Auch in diesen haben die MasseLeitungen einen endlichen Widerstand. Die durch sie abfließenden Ströme bauen daher, wenn auch nur sehr geringe, Spannungen auf. Über der Länge der Masse-Leitungen entstehen damit Potentialdifferenzen. Dies beeinträchtigt die Wiedergabe. Zum Ausschalten dieser Potentialdifferenzen oder mindestens zu deren Rückführung auf ein Minimum sieht die Erfindung vor, daß sämtliche Masse-Leitungen einen geringeren spezifischen Widerstand als die Signal-Leitungen und untereinander den gleichen Widerstand aufweisen.

EP 0 385 258 A2

## Schaltungsanordnung zur Ausschaltung von Potentialdifferenzen und zur Signallinearisierung

Die Erfindung betrifft eine Schaltungsanordnung zur Ausschaßtung von Potentialdifferenzen und zur Signallinearisierung bei aus einem Netzteil und verschiedenen Baugruppen bestehenden Aufnahme- und Wiedergabeanlagen für Ton und Sprache mit Masseleitungen zwischen den verschiedenen Bauteilen, -gruppen und Geräten und mit Signalleitungen, wobei die Masse-Leitungen teilweise einen geringeren spezifischen Widerstand als die Signalleitungen aufweisen.

Auf dem Gebiet der HiFi-Niederfrequenz-Verstärker wird ein sehr großer Aufwand betrieben, um eine Beeinflussung der Tonsignale durch Potentialdifferenzen auf den Signal- und insbesondere auch auf den Masseleitungen zu vermeiden. So gehen die Hersteller von Spitzengeräten bei Vor- und Endverstärkern unter anderem zum sogenannten symmetrischen Aufbau ihrer Geräte über. Dabei legen sie zum Beispiel den Eingang ihrer Geräte symmetrisch aus. Damit erreichen sie eine verbesserte Signalwiedergabe (vgl. Zeitschrift Stereoplay 3, 1986, Seiten 30, 36, 40; Zeitschrift Hifi-Vision 5, 1986, Seite 18). Die Firma Sansui zum Beispiel baut - mit ihrer sogenannten X-Balanced-Typ I-Serie - Verstärker, die völlig symmetrisch aufgebaut sind, um Potentialdifferenzen innerhalb der Erdschleife zu verhindern (vgl. Blockdiagramm im Hifi-Prospekt Sansui). Zudem wird als weitere Maßnahme, um den Einfluß von Störspannungen zu unterdrücken, die sogenannte Gegenkopplung nur noch begrenzt eingesetzt. Bei starker Gegenkopplung wird zwar der Klirrfaktor herabgesetzt, aber nach Untersuchungen von M. Otala entstehen sogenannte dynamische Verzerrungen (vgl. hierzu "hk 600 Serie" Vollverstärker-Prospekt von harman/kardon; vgl. auch Zeitschrift HiFi-Vision 4, 1986, Seite 17). Um Spannungsunterschiede innerhalb der Signalstromkreise auszuschal ten, verwendet der Hersteller Onkyo eine zusätzliche Ausgleichsleitung zwischen Vor- und Endverstärker (vgl. Zeitschrift HiFi-Vision 4, i986, Seite 19 und Seite 23 Kasten).

Zum Ausschalten von Potentialdifferenzen und zur Signalisierung zwischen dem speisenden Netz-Primärstromkreis, dem Sekundärstromkreis und den zu linearisierenden weiteren sekundären Signalstromkreisen und auch bei Verstärkern und Lautsprechern wird auch eine besondere Ausgleichsleitung zwischen Masse und den wichtigen elektrischen oder elektronischen Einzelelementen innerhalb der zu linearisierenden Stromkreise verlegt (DE-PS 3 617 798). Bekannt ist weiter, Masse-Leitungen gezielt niederohmig auszulegen. Unter gezielt wird dabei verstanden, nur bestimmte Masseleitungen niederohmig auszubilden. So werden Kondensatoren über besonders kurze Anschlußleitungen an weitere Bauelemente angelötet. Ebenso werden Entstörbauelemente über besonders kurze Leitungen angeschlossen (Nührmann, Dieter, Das große Werkbuch Elektronik, Teil A, Franzis-Verlag, 1989). Ebenso ist bekannt, auf einer Leiterplatte angeordnete Bauelemente zusätzlich zu erden. Dadurch ergeben sich niederohmige Masse-Leitungen (Das TTL-Kochbuch, Texas Instruments, 1980, Seiten 75 bis 79). Bei diesem Stand der Technik befinden sich damit zwischen einigen Bauteilen und Baugruppen Masse-Leitungen, die gegenüber den zu anderen Bauteilen und Baugruppen führenden Masse-Leitungen niederohmig sind. Im Vergleich zu den Signalleitungen weisen diese Masse-Leitungen einen geringeren spezifischen Widerstand auf. Festzuhalten ist aber, daß diese Niederohmigkeit nur für einen Teil der Masse-Leitungen gilt. Nur auf diesen Masse-Leitungen bilden sich Potentialdifferenzen nicht aus. Mögliche Spannungen oder Potentiale werden sofort über Masse abgeleitet. Innerhalb der Gesamtheit der Masse-Leitungen können beim Stand der Technik Potentialdifferenzen trotzdem auftreten. Diese Potentialdifferenzen beeinflussen die Signalstromkreise und beeinträchtigen die Linearität der Signale. Auch werden an Stellen, an denen die Masse-Leitungen ihren spezifischen Widerstand verändern, Signale reflektiert.

Von diesem Stand der Technik ausgehend liegt der Erfindung die Aufgabe zugrunde, eine Schaltungsanordnung so auszubilden, daß auch solche durch Potentialdifferenzen und Reflexionen auftretende Störungen mit Sicherheit vermieden werden. Zur Lösung dieser Aufgabe bietet die Erfindung bei einer Schaltungsanordnung der eingangs genannten Gattung zwei Wege an. Der eine Weg liegt darin, daß sämtliche Masse-Leitungen einen geringeren spezifischen Widerstand als die Signal-Leitungen aufweisen. Der zweite Weg liegt darin, daß sämtliche Masse-Leitungen den gleichen spezifischen Widerstand aufweisen. Die Lehre der Erfindung erschöpft sich damit nicht darin, einigen ausgewählten Masse-Leitungen einen geringeren spezifischen Widerstand als den Signal-Leitungen zu geben. Die Erfindung lehrt, daß sämtliche Masse-Leitungen dieser Vorschrift folgen sollen, einen geringeren spezifischen Widerstand als die Signal-Leitungen aufzuweisen. Dabei können, wenn ein noch höherer Grad der Vollkommenheit erreicht werden soll, sämtliche Masse-Leitungen den gleichen spezifischen Widerstand aufweisen. Bei Befolgung dieser erfindungsgemäßen Lehre entfallen die zahlreichen beim Stand der Technik vorhandenen Übergangswiderstände innerhalb der Erdschleife. Wegen dieses Wegfalls von Übergangswiderständen können auch Potentialdifferenzen nicht mehr auftreten. Ebenso entfallen Signalreflexionen. Weiter wird gleiches Grund- oder Bezugspotential für sämtliche Stromkreise und Speisespannungsquellen sichergestellt. Infolge des ständigen Bezugs auf gleiches Potential bleiben Spannungen und Ströme unbeeinträchtigt. Es leuchtet ein, daß die Tonwiedergabe von HiFi-Tonverstärkeranlagen noch weiter verbessert wird und sich einem Ideal annähert. Die praktische Anwendung der Erfindung mag hohe Kosten verursachen. Tonfrequenzverstärker, wie sie zum Beispiel in Rundfunkanstalten verwendet werden, kosten aber sowieso schon Unsummen. Für hochwertige HiFi-Tonverstärkeranlagen werden teilweise schon Preise gezahlt, die nur als Liebhaberpreise angesehen werden können. Deshalb ist ein durch die Erfindung bedingter weiterer Aufpreis gerechtfertigt, zumal die Qualität der Tonfrequenzwiedergabe überproportional steigt. In zweckmäßigen Weiterentwicklungen weist die Erfindung auch Wege, wie sich die Kosten senken lassen.

Es wurde ausgeführt, daß die Erfindung zwei voneinander unabhängige Wege zur Lösung der gestellten Aufgabe weist. Beide Wege können jedoch auch gemeinsam beschritten werden. So schlägt die Erfindung in einer weiteren Ausgestaltung vor, daß sämtliche Masse-Leitungen einen geringeren Widerstand pro Längeneinheit als die Signal-Leitungen und untereinander gleichen Widerstand aufweisen.

Zur Ausbildung der Masse-Leitungen schlägt die Erfindung als eine Möglichkeit vor, daß die Kaschierung von Leiterplatten eine Masse-Leitung bildet. Zum Ausbilden einer besonders niederohmigen Masse-Leitung sieht die Erfindung in einer weiteren Ausgestaltung vor, daß mehrere parallele Leiter eine Masse-Leitung darstellen. Die Erfindung läßt ebenfalls zu, daß die Masse-Leitungen durch Masseschienen und eine Verlängerung dieser Masseschienen dargestellt werden. Ebenso können die Masse-Leitungen durch die Abschirmung von Kabeln dargestellt werden.

In einer weiteren zweckmäßigen Ausgestaltung sieht die Erfindung vor, daß der Masseanschluß der Primärwicklung eines Transformators einer Speisespannungsquelle an einen Masse-Leiter angeschlossen ist und einen Netzstecker aufweist, der nur in einer Stellung in eine zugehörige Steckdose einsteckbar ist. Hiermit wird sichergestellt, daß der Masseanschluß der Primärwicklung des Netztransformators nicht an einen Spannung führenden Leiter in der Steckdose, sondern nur an den Masse- oder Neutralleiter angeschlossen wird. Zum Erreichen dieses Zieles wird ein besonderer, in bezug auf seine Pole nicht vertauschbarer Stecker verwendet. Das erfindungsgemäße Ziel läßt sich jedoch auch ohne einen solchen Stecker erreichen. Hierzu ist vorgesehen, daß der Neutralleiteranschluß der Primärwicklung eines Transformators einer Speisespannungsquelle an ei nen Masse-Leiter angeschlossen ist und eine elektronische Regelung den Neutralleiteranschluß und die Spannung führende Phase des Netzes so schaltet, daß der Neutralleiteranschluß der Primärwicklung unabhängig von der Stellung des Netzstekkers immer am Neutralleiteranschluß des Netzes liegt.


Ausführungsbeispiel

Gerätekombination: CD-Player, NF-Endverstärker, Lautsprecher (passiv) (maximaler Anwendungsumfang).

Bezugsgröße für die Dimensionierung sind die größten notwendigen Phasen-Leiterquerschnitte. Innerhalb dieser Kombination ist der Querschnitt des Lautsprecherkabels entsprechend seiner Länge sowie der Stärke der zu übermittelnden Ströme Bezugsgröße. Üblicherweise werden Querschnitte von zweimal 0,75 mm$^2$ bis zweimal 6 mm$^2$ (seltener bis zweimal 10 mm$^2$ oder größer) angewendet.

Ein qualitativ noch vertretbarer Mittelwert liegt für Kabellängen unter 10 m bei einem handelsüblichen Wert von zweimal 2,5 mm$^2$ Querschnitt. Die folgenden Angaben beziehen sich auf Lautsprecherkabel bis zu 10 m Länge und getrennte Aufstellung von Verstärker und Lautsprecher. 2,5 mm$^2$ Bezugsgröße für die Phasenleiter der Lautsprecheranschlußkabel verlangen zur Erzielung ausgezeichneter Ergebnisse, für die masseseitig zehnbis zwanzigfach größer dimensioniert werden muß, Rückleiter oder Masseleiter der Lautsprecher mit 25 mm$^2$ bis 50 mm$^2$ Querschnitt, aufgebaut zum Beispiel aus zweimal 2,5 mm$^2$, sowie zusätzlich fünf Litzen aus zweimal 4 mm: für Masse. Daraus folgt ein Verhältnis Phasenhinleitung zu Masse-Signalrückleitung von etwa 1 : 17. Dieses Verhältnis kann bei Leiterlängen unter 10 m proportional reduziert werden, bei 3 m zum Beispiel auf zirka 1 : 6. Größere Querschnitte zeigen jedoch noch deutlichere Wirkung: Die Signalrückleitung führt nach be kannten Prinzipien sternförmiger Verdrahtung unmittelbar bis zu den Massepolen der Lautsprecher und an die LautsprecherNetzwerkelektronik zum Beispiel der Filter. Diese Teile können masseseitig auch direkt an die Leitung angeschlossen werden. Im Verstärker werden idealerweise alle Bauteile masseseitig unmittelbar an eine Masseleitung oder Schiene angeschlossen. Deren Widerstand entspricht pro Längeneinheit etwa der Lautsprechersignalrückleitung, zum Beispiel einer Kupferschiene 3 mm x 15 mm, mit 45 mm$^2$ Querschnitt. Diese Schiene wird querschnittsgemäß aus dem Gerät herausgeführt. An diesen Querschnitt sind die Lautsprecherrückleitung sowie eine gleichwertige Signalrückleitung zur Signalquelle, das heißt dem CD-Player, anzubringen. Innerhalb der Geräte kann diese Funktion auch von ganzseitig kaschierten breiten Masse-Leiterplatten erfüllt werden. Der CD-Player wird innen, wie für den Verstärkeraufbau bereits beschrieben, aufgebaut.

Falls zwischen Verstärker und CD-Player zur Signalübertragung herkömmliche Verbindungskabel eingesetzt werden, können beispielsweise wieder fünf Litzen parallel mit jeweils zweimal 4 mm² Querschnitt die Verstärkermasseschiene und die CD-Player-Masseschiene verbinden.

Mit diesem Aufbau kann die Kombination so eingerichtet werden, daß sich von der ersten Signalstation (Laserdiode) bis zum letzten signalverarbeitenden Teil (Lautsprecherchassis) durchgehend annähernd gleiches Potential mit extrem geringeren Widerstandswerten für die Masseleiter gegenüber den Spannung führenden Leitern innerhalb sämtlicher Signalrückleitungsabschnitte ergibt. Auf diese Weise können auch Übergangswiderstände innerhalb sämtlicher Masseleiter ausgeschaltet werden.

Zur logisch konsequenten vollständigen Anwendung dieses Prinzips gehört auch die Einbeziehung des speisenden Netzstromkreises, der die Geräte mit Spannung versorgt. Sekundärseitig ist dies zum Beispiel über eine Trafo-Sekundärspule mit Mit telpunktserdung relativ einfach durchzuführen. Auf der Primärseite wechselt der Phasenleiter aufgrund der Polvertauschbarkeit der Geräte-Netzstecker (180° Drehungsmöglichkeit des Gerätesteckers beim Einstecken in eine Licht-Steckdose) zum Neutralleiter und umgekehrt. Dieser mögliche Polwechsel schließt das Anschließen einer Signallinearisierungsleitung direkt an die Trafo-Primärspule aus. Durch die mögliche Gerätesteckerdrehung um 180° beim Einstecken in die Licht-Steckdose würde der Netz-Phasenleiter mit Masse verbunden.

Auch Spulen erzeugen Störspannungen und sollen in die Konzeption einbezogen werden. Bei konsequenter und wirkungsvoller Durchführung empfiehlt sich die folgende Konstruktion: Auch die Primärspulen der speisenden Netztrafos der Kombination werden einseitig mit dem linearisierenden Masseleitungssystem verbunden. Dazu ist dieser elektrische Verbindungspunkt eindeutig und unvertauschbar als Neutralleiteranschluß der NetzPrimärtrafospule festzulegen, der gegen Erde keine Spannung führt. Hierzu müssen die Geräte mit einem unvertauschbaren Netzstecker versehen sein. Hier muß ein Stecker mit festen und unvertauschbaren Anschlüssen verwandt werden. Aus Gründen der Kompatibilität empfiehlt sich hierfür eine abgeänderte Ausführungsform des herkömmlichen Schutzkontaktsteckers. Bei diesem stellen zum Beispiel zusätzlich eingegossene, nicht spannungsführende Stifte die Unvertauschbarkeit sicher. Diese Stecker benötigen eine besondere Steckdose, die mit herkömmlichen Netzsteckern kompatibel ist.

Aufgrund der festen Polbelegung der Geräte-Netzanschlüsse kann der speisende Netzstromkreis der Geräte unmittelbar einbezogen werden. Bei Weiterverwendung herkömmlicher Netzstekker kann eine elektrische/elektronische Regelung die Netzphasen primärseitig bei 180° Drehung der Netzgerätestecker automatisch richtig für die Festbelegung der Netzphasen umschalten.

Anmerkungen:

1. Das Ausführungsbeispiel benötigt zur Inbetriebnahme als Hilfsvorrichtung unter Umständen zusätzlich noch einen Spannungsregler (Lautstärkeregler), weil CD-Player und viele End-Verstärker vielfach ohne Lautstärkeregelung angeboten werden. Die Lautstärkeregelung kann über ein Qualitätspotentiometer im Kleinpultgehäuse erfolgen. Dieses Potentiometer sollte dann jedoch in die beschriebenen Maßnahmen einbezogen werden und ebenfalls masseseitig mit einer Signalrückleitung oder einer Masseleitung des beschriebenen Querschnitts verbunden sein.

2. Gemäß der hier vorgestellten erfinderischen Lehre erscheint es zusätzlich sinnvoll, sowohl bei diskreten Bauteilen, Widerständen, Spulen, Kondensatoren, als auch bei integrierten Schaltungen (ICs) die Masseleiter einseitig mit größeren Querschnitten aus den genannten Bauteilen herauszuführen als deren Phasenleiter bzw. in integrierten Schaltungen (ICs) die Masseleiter durchgehend mit größeren Massequerschnitten als Phasenleiterquerschnitten zu versehen.

**Ansprüche**

1. Schaltungsanordnung zur Ausschaltung von Potentialdifferenzen und zur Signallinearisierung bei aus einem Netzteil und verschiedenen Baugruppen bestehenden Aufnahmeund Wiedergabeanlagen für Ton und Sprache mit Masseleitungen zwischen den verschiedenen Bauteilen, -gruppen und Geräten und mit Signalleitungen, wobei die Masse-Leitungen teilweise einen geringeren spezifischen Widerstand als die Signalleitungen aufweisen, dadurch gekennzeichnet, daß sämtliche Masse-Leitungen einen geringeren spezifischen Widerstand als die Signal-Leitungen aufweisen.

2. Schaltungsanordnung zur Ausschaltung von Potentialdifferenzen und zur Signallinearisierung bei aus einem Netzteil und verschiedenen Baugruppen bestehenden Aufnahmeund Wiedergabeanlagen für Ton und Sprache mit Masseleitungen zwischen den verschiedenen Bauteilen, -gruppen und Geräten und mit Signalleitungen, wobei die Masse-Leitungen teilweise einen geringeren spezifischen Widerstand als die Signalleitungen aufweisen, dadurch gekennzeichnet, daß sämtliche Masse-Leitungen den gleichen spezifischen Widerstand aufweisen.

3. Schaltungsanordnung nach einem der Ansprüche 1 oder 2, dadurch gekennzeichnet, daß sämtliche Masse-Leitungen einen gleichen und einen niedrigeren Widerstand pro Längeneinheit als die Signal-Leitungen aufweisen.

4. Schaltungsanordnung nach einem der Ansprüche 1 bis 3, dadurch gekennzeichnet, daß die Kaschierung von Leiterplatten eine Masse-Leitung bildet.

5. Schaltungsanordnung nach irgendeinem der Ansprüche 1 bis 4, dadurch gekennzeichnet, daß mehrere parallele Leiter eine Masse-Leitung darstellen.

6. Schaltungsanordnung nach einem der Ansprüche 1 bis 5, dadurch gekennzeichnet, daß die Masse-Leitungen durch Masseschienen und eine Verlängerung dieser Masseschienen dargestellt werden.

7. Schaltungsanordnung nach irgendeinem der Ansprüche i bis 6, dadurch gekennzeichnet, daß die Masse-Leitungen durch die Abschirmung von Kabeln dargestellt werden.

8. Schaltungsanordnung nach irgendeinem der Ansprüche 1 bis 7, dadurch gekennzeichnet, daß der Neutralleiteranschluß der Primärwicklung eines Transformators einer Speisespannungsquelle an einen Masse-Leiter angeschlossen ist und einen Netzstecker aufweist, der nur in einer Stellung in eine zugehörige Steckdose einsteckbar ist.

9. Schaltungsanordnung nach irgendeinem der Ansprüche 1 bis 8, dadurch gekennzeichnet, daß der Neutralleiteranschluß der Primärwicklung eines Transformators einer Speisespannungsquelle an einen Masse-Leiter angeschlossen ist und eine elektronische Regelung den Neutralleiteranschluß und die Spannung führende Phase des Netzes so schaltet, daß der Neutralleiteranschluß der Primärwicklung unabhängig von der Stellung des Netzsteckers immer am Neutralleiteranschluß des Netzes liegt.